# EUROPEAN PATENT SPECIFICATION

(11) **EP 1 241 677 B1**
(45) Date of publication and mention of the grant of the patent: **07.06.2006**
(21) Application number: 02005757.6
(22) Date of filing: 13.03.2002
(51) Int. Cl.: G11C 16/34, G11C 16/10

(54) **Semiconductor device using non-volatile memory in which data is written circularly**
Nichtflüchtiger Halbleiterspeicher mit zirkularem Einschreiben
Mémoire non-volatile avec écriture circulaire

(30) Priority: 14.03.2001 JP 2001073170
(43) Date of publication of application: 18.09.2002
(73) Proprietor: NEC Electronics Corporation, Kawasaki, Kanagawa 211-8668 (JP)
(72) Inventor: Isogai, Hideo, Tokyo (JP)
(74) Representative: Glawe, Delfs, Moll

(56) References cited:
- FR-A- 2 665 791
- FR-A- 2 712 412
- FR-A- 2 730 833
- US-A- 4 780 855
- PATENT ABSTRACTS OF JAPAN vol. 016, no. 182 (P-1346), 30 April 1992 (1992-04-30) -& JP 04 021999 A (MITSUBISHI ELECTRIC CORP), 24 January 1992 (1992-01-24)

## Description

### Background of the Invention

### 1. Field of the Invention

The present invention relates to a semiconductor device. More particularly, the present invention relates to a semiconductor device having a built-in non-volatile memory in which a permissive number of times of rewrite is limited.

### 2. Description of the Related Art

Non-volatile memories are known such as EEPROM (Electrically Erasable Programmable Read Only Memory), a flash memory and FeRAM (Ferroelectric Random Access Memory). The non-volatile memory which can hold data without any power supply is suitable for a data memory for an IC card. In such a non-volatile memory, the permissive number of times of rewrite is presently limited. The permissive number of times of rewrite of the EEPRO is limited to about 10⁵, the permissive number of times of rewrite of the flash memory is limited to about 10⁴, and the permissive number of times of rewrite of the FeRAM is limited to about 10¹⁰.

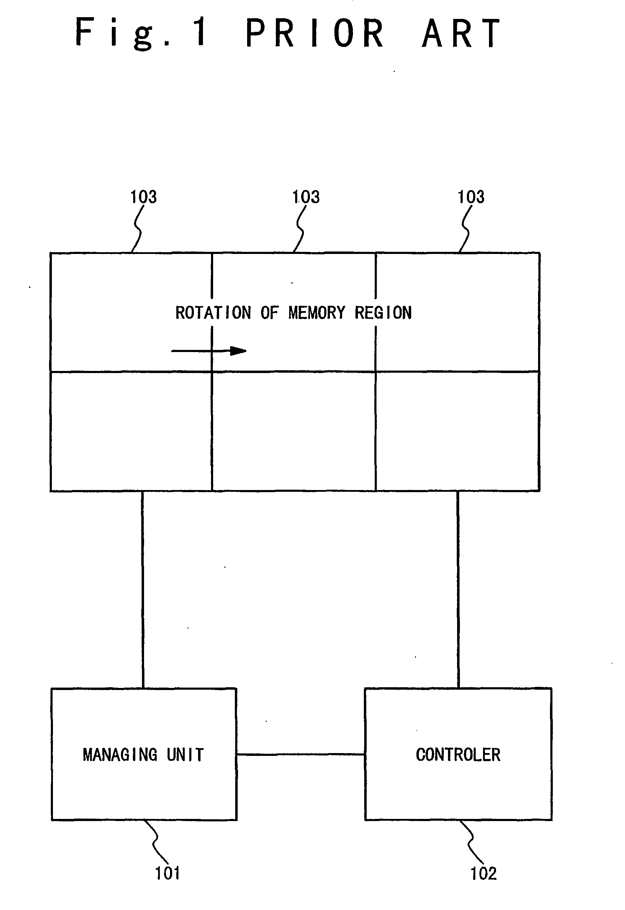

A data managing method is disclosed in Japanese Laid Open Patent Application (JP-A-Heisei 5-151097), in which circulation of a memory region to be accessed is carried out in accordance with the permissive number of times of rewrite for solving the above problem. Fig. 1 shows a conventional memory device to which the conventional data managing method is applied. The memory is limited in the permissive number of times of rewrite, and has a managing unit 101, a controller 102 and a plurality of memory regions 103. The managing unit 101 manages the number of times of rewrite of each memory region 103. The controller 102 selects one for data to be written from the memory regions 103 based on the permissive number of times of rewrite of each memory region 103. The controller 102 compares the numbers of times of rewrite of the memory regions 103, and selects the memory region with the minimum number of time of rewrite. The rewriting operation is carried out to the memory region with the minimum number of times of rewrite.

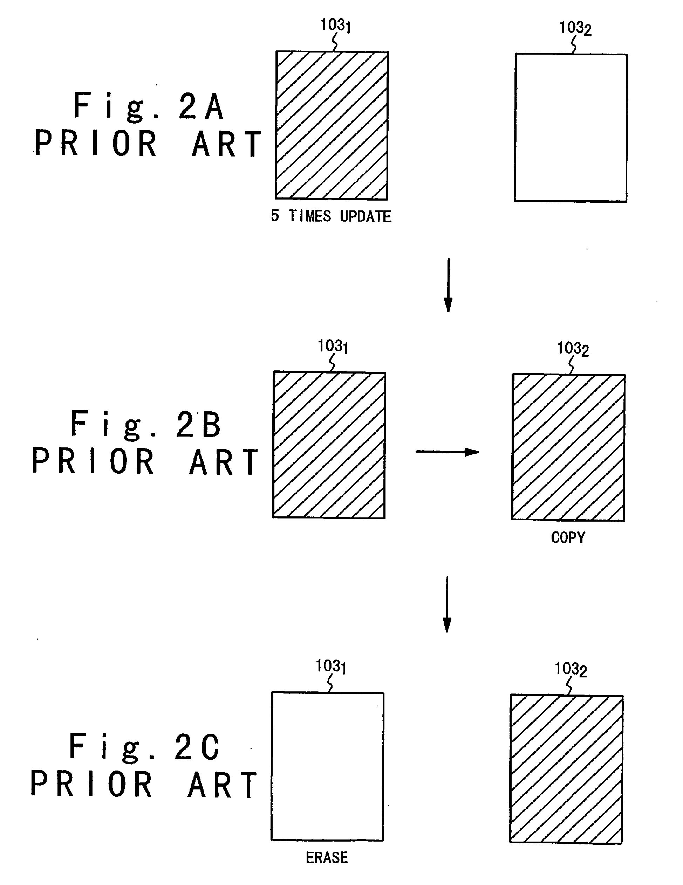

Figs. 2A to 2C show an operation of the conventional memory device in which the permissive number of times of rewrite is limited. It is supposed that a first semiconductor chip as a first memory region 103₁ of the memory regions 103 is already rewritten five times and a second semiconductor chip as a second memory region 103₂ of the memory regions 103 is not yet used. The number of times of rewrite of the first memory chip 103₁ and that of rewrite of the second memory chip 103₂ are compared with each other, and the second memory chip 103₂ with the smaller number of times is smaller is selected as a memory chip for the data to be rewritten. Contents of the first memory chip 103₁ are copied to the second memory chip 103₂. After that, the second memory chip 103₂ is used. The first memory chip 103₁ is collectively erased in units of chips. The first memory chip 103₁ is not used until the number of times of rewrite of the second memory chip 103₂ exceeds that of rewrite of the first memory chip 103₁.

In this way, the change of the memory chip 103 to be used is carried out so as to always use the memory chip with the minimum number of times of rewrite from among the plurality of memory chips 103. Thus, the memory chips 103 are accessed in the same number of times. If the number of the memory chips 103 is N, the lifetime of the memory chips 103 is elongated to N times.

In the conventional data managing method, it is necessary to refer to the numbers of times of rewrite of all of the memory regions 103 and further compare them in order to determine the memory region 103 to be used for the rewrite from among the plurality of memory regions 103. This results in the complex process to determine the memory region to be used for the rewrite.

In conjunction with the above description, a write method of a rewitable ROM is disclosed in Japanese Laid Open Patent application (JP-A-Heisei 9-265427). In this reference, the data region of the ROM is divided into blocks with a predetermined block length. Each of the blocks is allocated with an address. A CPU specifies one of the blocks based on a block address and data and writes a file in units of blocks. At this time, the CPU writes the file from an empty block when there is the empty block with a write start mark and from an optimal empty block when there is no empty block with the mark. After completion of the write of the file, the CPU searches an empty block in a downstream direction and writes the write start mark in the searched empty block.

Also, a semiconductor memory device is disclosed in Japanese Laid Open Patent application (JP-A-Heisei 8-96588). In this reference, the memory device is of a non-volatile type. A data storage section has at least one block, which can be independently written and erased, in a data storage region of the non-volatile memories. A block selecting section calculates a physical address from a logical address to specify one of the blocks. A search section searches an unused block from the data storage section. An erasure managing section manages initial erasure of the blocks. Data is written in the selected block and the block selecting section specifies the searched block as an object.

It is desirable to provide another technique for fictionally extending the lifetime of the non-volatile memory in which the permissive number of times of rewrite is limited. In particular, it is desirable to provide the technique for simply determining the memory region to be used for the rewrite and also performing the change of the used memory region, and thereby fictionally extending the lifetime of the non-volatile memory.

Also, in such a non-volatile memory, it is desirable that the data stored in the non-volatile memory is not damaged even if the power supply to the non-volatile memory is interrupted during the access to the non-volatile memory. If the non-volatile memory is used as a data memory for an IC card, the sudden interruption of the power supply is assumed to be frequently brought about. For example, if the non-volatile memory is used in a contact type IC card, the contact type IC card may be suddenly pulled out from a power supply terminal by a user. Moreover, if a non-contact type IC card to which power is supplied with electric wave is separated from a transmitter of the electric wave, there may be a case that a necessary power supply voltage cannot be kept. If the IC card is actually used in a dairy life, the interruption of the power supply is assumed to be brought about during the access to the non-volatile memory. If the non-volatile memory is used as the data memory for the IC card, it is important that the data stored in the non-volatile memory is not damaged even if the power supply is interrupted.

A semiconductor device according to the preamble part of claim 1 is known from FR-A-2 665 791 and to US-A-4 780 855. FR-A-2 730 833 discloses a message for updating a memory wherein the data reconstruction process is based on the fact that the data usually held in regions of a principle memory are saved in regions of a safety memory.

### Summary of the Invention

Therefore, it is an object of the present invention to provide a semiconductor device reducing the risk that data stored in a non-volatile memory is damaged if the power supply is interrupted and in which the interruption of a power supply is detected if the power supply is interrupted.

These objects are solved by the features of claims 1 and 6.

Advantages embodiments are mentioned in the subclaims.

### Brief Description of the Drawings

Fig. 1 shows a conventional memory device;
Figs. 2A to 2C show an operation of the conventional memory device;
Fig. 3 shows a semiconductor device according to a first embodiment of the present invention;
Fig. 4 shows the configuration of a pointer flag and possible states of the pointer flag;
Figs. 5A to 5E show a process for updating data in the semiconductor device of the first embodiment;
Fig. 6 is a flowchart showing the process for updating the data in detail;
Figs. 7A to 7E show a process for reading out data from a data region;
Fig. 8 is a flowchart showing the process for reading out the data from the data region in detail;
Figs. 9A and 9B are diagrams showing the state of the data region when the power supply is interrupted during the update of the data region and the state of the pointer flag when the power supply is interrupted during the update of the pointer flag;
Fig. 10 shows a semiconductor device according to a second embodiment of the present invention;
Fig. 11 shows the configuration of a power interruption check pointer flag;
Figs. 12A to 12D show a process for updating data in the semiconductor device in the second embodiment;
Figs. 13A to 13D show a process for updating data in the semiconductor device of the second embodiment;
Fig. 14 shows a semiconductor device according to a third embodiment of the present invention; and
Figs. 15A to 15D shows a process for updating data in the semiconductor device of the third embodiment.

### Description of the Preferred Embodiments

Hereinafter, a semiconductor device of the present invention will be described below with reference to the attached drawings.

### (First Embodiment)

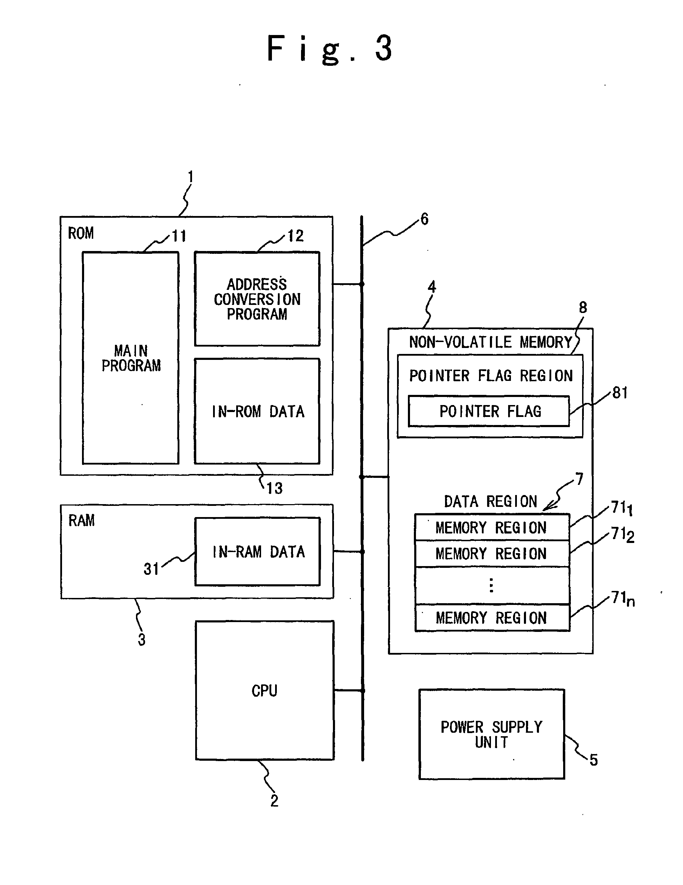

Fig. 3 shows a semiconductor device according to the first embodiment of the present invention. The semiconductor device is used for an IC card. The semiconductor device includes a ROM 1, a CPU 2, a RAM 3, a non-volatile memory 4 and a power supply unit 5. The ROM 1, the CPU 2, the RAM 3 and the non-volatile memory 4 are connected to each other through a bus 6.

Power is supplied from the power supply unit 5 through a power supply line (not shown) to the ROM 1, the CPU 2, the RAM 3 and the non-volatile memory 4. When the semiconductor device is used in a non-contact type IC card, a combination of a coil antenna and a regulator is selected as the power supply unit 5. When the semiconductor device is used in a contact type IC card, a power supply unit for converting a power supply voltage supplied from an external portion into a power supply voltage to be used in the semiconductor device is selected as the power supply unit 5.

The ROM 1 stores therein a main program 11, an address conversion program 12 and in-ROM data 13.

The main program 11 describes the whole operation of an IC card. The semiconductor device is operated in accordance with the main program 11.

The address conversion program 12 is a program for converting a virtual or logical address into a physical address. In the main program 11, the logical address is used to specify an address if an access to a memory space is carried out. The logical address is converted into the physical address using the address conversion program 12. The access is actually carried out to a region of the ROM 1, the RAM 2 and the non-volatile memory 4 which are specified by the physical address.

The in-ROM data 13 contains only data to be read out, of the data used in the main program 11.

The CPU 2 executes the main program 11 and the address conversion program 12, and then controls the whole operation of the semiconductor device of the present invention.

The RAM 3 stores therein in-RAM data 31. The in-RAM data 31 contains the data on which a re-written operation is frequently performed, of the data used in the main program 11.

The data which needs to be stored in the non-volatile manner and needs to be re-written are written to the non-volatile memory 4. The data are used in the main program 11. In the main program 11, it is supposed that data is stored in a logical address X. If the logical address X specifies a region of the non-volatile memory 4, and the region of the non-volatile memory 4 is assigned to store the data of the logical address X. In the non-volatile memory 4, the region assigned to store the data used in the main program 11 is hereafter referred to as the data region 7. If a plurality of data are used in the main program 11, a plurality of data region 7 are assigned in correspondence to them. However, a single data region 7 is shown in Fig. 3.

The data region 7 is provided with a plurality of memory regions 71₁ to 71ₙ. Here, n is an integer of 2 or more. The CPU 2 determines n when an instruction is inputted or information about the data such as a kind of data, and a location of the data in a data stream. However, the value of n may be fixed or predetermined. The CPU 2 reserves the data region 7 in the non-volatile memory 4 based on the determined value of n. When the data is written in the data region 7, any of the memory regions 71_{1₁} to 71ₙ is circularly selected. The data to be stored in the data region 7 is written in the memory region selected from among the memory regions 71₁ to 71ₙ. On the other hand, if the data is read out from the data region 7, the data is read out from the memory region, to which the latest writing operation is carried out, of the memory regions 71₁ to 71ₙ.

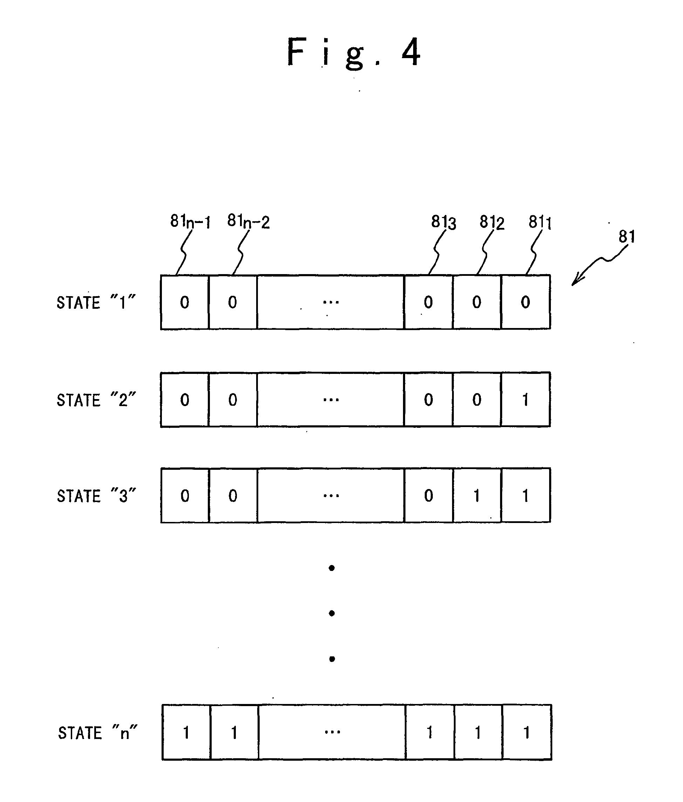

Another portion of the non-volatile memory 4 is assigned to a pointer flag region 8. A pointer flag 81 is stored in the pointer flag region 8. If a plurality of data regions 7 are provided in the non-volatile memory 4, one pointer flag 81 is provided for each data region 7. Fig. 3 shows only one pointer flag 81. The pointer flag 81 specifies one to be accessed of the memory regions 71₁ to 71ₙ. The pointer flag 81 is provided with (n-1) bits (81₁ to 81ₙ₋₁) as shown in Fig. 4. Here, n is the number of the memory regions 71₁ to 71ₙ. The number of bits 81₁ to 81ₙ₋₁ of the pointer flag 81 is smaller by one than the number of the memory regions 71₁ to 71ₙ. Hereafter, a bit 81ₖ of the pointer flag 81 is represented as the lower order bit as the affix k is smaller.

The pointer flag 81 of the (n-1) bits is in either one of states 1 to n. The state 1 is the state in which all of the bits 81₁ to 81ₙ₋₁ are 0. The state 2 is the state in which the bit 811 is "1" and the remaining bits 81₂ to 81ₙ₋₁ are "0". Similarly, the state k is the state in which the bits 81₁ to 81ₖ₋₁ are "1" and the remaining bits 81ₖ to 81ₙ₋₁ are "0". Here, k is an integer between 1 and n. However, in a case of k=n, the state n is the state in which all of the bits 81₁ to 81ₙ₋₁ are "1".

A memory region to be accessed of the memory regions 71₁ to 71ₙ is specified based on the state of the pointer flag 81. In case of the access to the data stored in the data region 7, the pointer flag 81 is referred by the CPU 2 using the address conversion program 12, and the memory region to be accessed of the memory regions 71₁ to 71ₙ is selected. Moreover, a physical address of the selected memory region is calculated by the address conversion program 12. Then, in the non-volatile memory 4, a portion specified by the physical address is accessed.

The correspondence between the state of the pointer flag 81 and the accessed memory region is as follows. If the pointer flag 81 is in the state 1, the data is read out from the memory region 71₁, and the data is written to the memory region 71₂. If the pointer flag 81 is in the state 2, the data is read out from the memory region 71₂, and the data is written to the memory region 71₃. Hereafter, similarly, if the pointer flag 81 is in the state k, the data is read out from the memory region 71ₖ, and the data is written to the memory region 71ₖ₊₁. However, if the pointer flag 81 is in the state n, the data is written to the memory region 71₁.

The number n of the memory regions 71₁ to 71ₙ is selected such that all of the (n-1) bits 81₁ to 81ₙ₋₁ contained in the pointer flag 81 can be reset to "0" in response to one command outputted by the CPU 2. This provides the important role so that the data stored in the non-volatile memory 4 is not damaged if the power supply to the respective section of the semiconductor device from the power supply unit 5 is suddenly interrupted, as described later.

The operation of the semiconductor device in this embodiment will be described below.

At first, an operation for writing data to the data region 7 will be described. In the following description, it is supposed that the data region 7 is assigned to store the data of a logical address X in a memory space. Moreover, a data to be firstly stored as the data of the logical address X is supposed to be noted as a data 1.

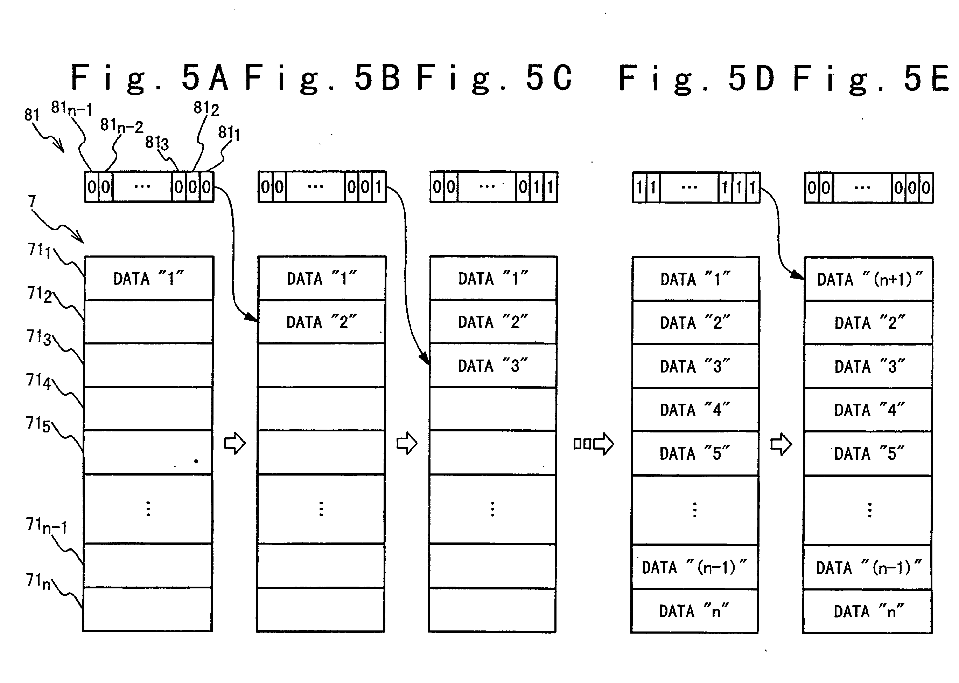

As the data of the logical address X, the data 1 to be firstly written to the data region 7 is written to the memory region 71₁ without any condition. After the data 1 is written to the memory region 71₁, the pointer flag 81 is set in the state 1. That is, all of the bits 81₁ to 81ₙ₋₁ included in the pointer flag 81 are reset to "0". Fig. 5A shows the states of the data region 7 and the pointer flag 81 after the completion of the process for writing the data 1.

After that, if the data of the logical address X is updated, the CPU 2 refers to the pointer flag 81 using the address conversion program 12, and determines which of the states 1 to n the pointer flag 81 is set to. If the pointer flag 81 is determined to be in the state k (k is an integer between 1 and n), the data to be stored in the data region 7 as the data of the logical address X is written to the memory region 71ₖ₊₁ of the memory regions 71₁ to 71ₙ. After that, the state of the pointer flag 81 is shifted or changed from the state k to the state k+1. However, if the data of the logical address X is updated when the pointer flag 81 is in the state n, the data to be stored in the data region 7 as the data of the logical address X is written to the memory region 71₁, and the state of the pointer flag 81 is shifted from the state n to the state 1.

The above-mentioned processes will be actually described below with reference to Figs. 5A to 5E. As mentioned above, the data 1 to be firstly stored as the data of the logical address X is written to the memory region 71₁ as shown in Fig. 5A. When the data 1 is written to the memory region 71₁, the pointer flag 81 is set in the state 1.

If the data of the logical address X is updated from the data 1 to the data 2, the address conversion program 12 refers to the pointer flag 81. At this time, the pointer flag 81 is in the state 1. Thus, as shown in Fig. 5B, the memory region 71₂ is selected as the destination to which the data 2 is written. The data 2 is written to the selected memory region 71₂.

Subsequently, the bit 81₂ in the pointer flag 81 is rewritten from "0" to "1". That is, the pointer flag 81 is shifted from the state 1 to the state 2. Fig. 5B shows the states of the data region 7 and the pointer flag 81 after the pointer flag 81 is rewritten.

When the data of the logical address X is updated from the data 2 to the data 3, the data 3 is also similarly written to the memory region 71₃, as shown in Fig. 5C. After it is written, the pointer flag 81 is shifted to the state 3.

After that, when the data of the logical address X is sequentially updated from the data 3, to the data 4, the data 5, ..., and the data n, the data 4, the data 5, ..., and the data n after the update are written to the memory region 71₄, the memory region 71₅, ..., and the memory region 71ₙ, respectively. Similarly, the pointer flag 81 is sequentially shifted to the state 4, the state 5, ..., and the state n. After the completion of the process for writing the data n, the pointer flag 81 is in the state n.

Subsequently, if the data of the logical address X is updated from the data n to the data (n+1), the pointer flag 81 is in the state n as shown in Fig. 5D. Thus, as shown in Fig. 5E, the memory region 71₁ is selected as the destination to which the data (n+1) is written. The data (n+1) is written to the memory region 71₁, and the pointer flag 81 is shifted from the state n to the state 1.

In this way, each time the data of the logical address X is updated, one of the memory regions 71₁ to 71ₙ is circularly selected, and the data to be stored as the data of the logical address X is written to the selected memory region. In this way, the circulation selection of the written memory regions 71₁ to 71ₙ enables the permissive number of times of rewrite of the data of the logical address X to be apparently greater than the permissive number of times of rewrite which is physically allowed for the non-volatile memory 4.

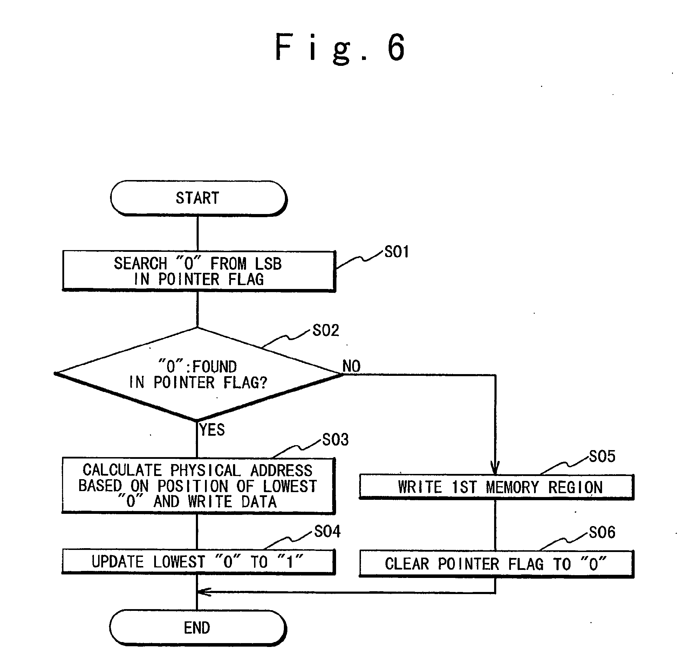

Fig. 6 is a flowchart showing the writing operation to be performed on the data region 7 in detail, if the data of the logical address X is updated. The program for executing the operation shown in the flowchart of Fig. 6 is written in the address conversion program 12. The CPU 2 carries out the operation shown in the flowchart of Fig. 6, in accordance with the address conversion program 12.

At first, it is determined whether or not each of the bits 81₁ to 81ₙ₋₁ is at "0". The determination is carried out in turn from the lower order bit 81₁ (Step S01).

Next, it is determined whether or not each of the bits 81₁ to 81ₙ₋₁ includes the bit of "0" (Step S02).

If any of the bits 81₁ to 81ₙ₋₁ is set to "0", a value i satisfying the following condition is determined (Step S03). The value i indicates a position of a least significant bit for which "0" is set. Condition: The bits 81₁ to 81ₙ₋₁ of the bits 81₁ to 81ᵢ₋₁ are "1", and the remaining bits 81ᵢ to 81ₙ₋₁ are "0". However, if all of the bits 81₁ to 81ₙ₋₁ are "0", it is determined to be i=1. The value i thus determined is any integer between 1 and n-1.

The fact that the bits 81z to 81ᵢ₋₁ are "1" and the remaining bits 81ᵢ to 81ₙ₋₁ are "0" implies that the pointer flag 81 is in the state i. If the pointer flag 81 is determined to be in the state i, the memory region 71ᵢ₊₁ of the memory regions 71₁ to 71ₙ is selected as the destination to which the data is written. The physical address of the selected memory region 71ᵢ₊₁ is calculated, and the data after the update of the logical address X is written to the region indicated by the physical address of the non-volatile memory 4 (Step S03).

After that, the bit 81ᵢ₊₁ among the bits 81₁ to 81ₙ₋₁ is updated from "0" to "1" (Step S04). Thus, the pointer flag 81 is shifted from the state i to the state i+1. The process for updating the data of the logical address X is ended as mentioned above.

On the other hand, at the step S02, if all of the bits 81₁ to 81ₙ₋₁ are at "1" and the bit of "0" is not found out, the head memory region 71₁ of the memory regions 71₁ to 71ₙ is selected as the destination to which the data is written. This implies that when the pointer flag 81 is in the state n, the memory region 71₁ is selected as the destination to which the data is written. The physical address of the selected memory region 71₁ is calculated, and the data after the update of the logical address X is written to the region indicated by the physical address of the non-volatile memory 4 (Step S05).

After that, all of the bits 81₁ to 81ₙ₋₁ contained in the pointer flag 81 are reset to "0" (Step S06). The bits 81₁ to 81ₙ₋₁ are collectively cleared in accordance with one command outputted from the CPU 2. If the address conversion program 12 instructs the CPU 2 to clear the bits 81₁ to 81ₙ₋₁, the CPU 2 outputs the command to instruct the non-volatile memory 4 to clear the bits 81₁ to 81ₙ₋₁. In accordance with the command, the non-volatile memory 4 clears all of the bits 81₁ to 81ₙ₋₁ to "0". In this way, the bits 81₁ to 81ₙ₋₁ are collectively cleared in accordance with the one command.

The operation for reading out the data from the data region 7 to which the data of the logical address X is written as mentioned above will be described below.

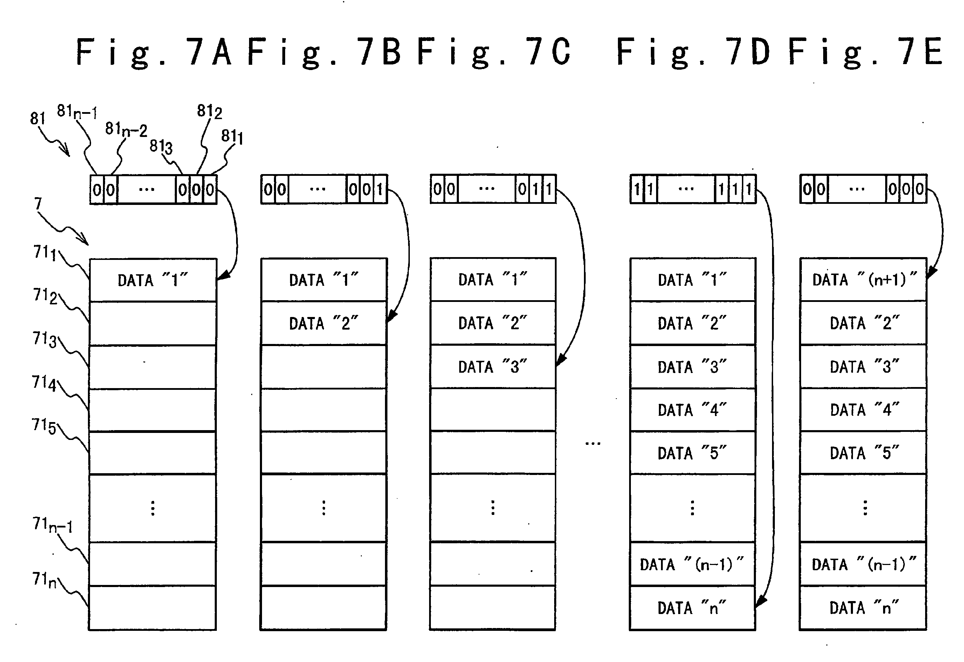

Figs. 7A to 7E are diagrams showing the operation for reading out the data from the data region 7. If the data of the logical address X is read out, the address conversion program 12 firstly refers to the pointer flag 81, and determines which of the states 1 to n the pointer flag 81 is set to.

If the pointer flag 81 is determined to be in the state j (j is an integer between 1 and n) of the states 1 to n, as the data of the logical address X, the data stored in the memory region 71ⱼ among the memory regions 71₁ to 71ₙ is read out. As mentioned above, immediately after the data is written to the memory region 71ⱼ, the pointer flag 81 is updated to the state j. Thus, the data written in the memory region 71ⱼ is the latest data of the logical address X. Since the data is read out from the memory region 71ⱼ when the pointer flag 81 is in the state j, the latest data of the logical address X is properly read out.

As shown in Fig. 7A, if all of the bits 81₁ to 81ₙ₋₁ contained in the pointer flag 81 are "0", the pointer flag 81 is in the state 1. At this time, if the data of the logical address X is read out from the data region 7, the memory region 71₁ is selected as the source from which the data is read out. Then, the data of the logical address X is read out from the selected memory region 71₁.

Similarly, as shown in Fig. 7B, if only the bit 81₁ of the bits 81₁ to 81ₙ₋₁ contained in the pointer flag 81 is "1" and the bits 81₂ to 81ₙ₋₁ are "0", the pointer flag 81 is in the state 2. In this case, the memory region 71₂ is selected as the source from which the data is read out, and the data of the logical address X is read out from the memory region 71₂.

As shown in Figs. 7C to 7E, even if the pointer flag 81 is at another state, the data is similarly read out.

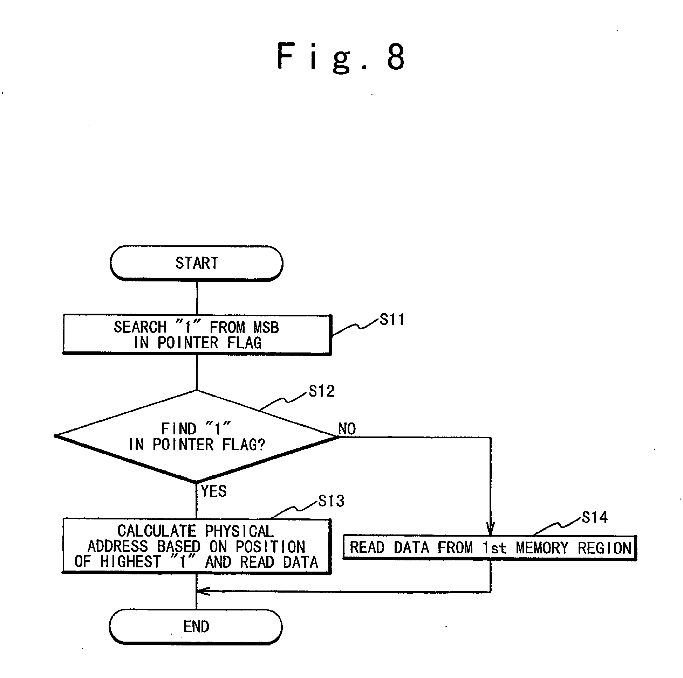

Fig. 8 is a flowchart showing the operation for reading out the data of the logical address X from the data region 7 in detail. The program for executing the operation shown in the flowchart of Fig. 8 is written in the address conversion program 12. The CPU 2 executes the operation shown in the flowchart of Fig. 8, in accordance with the address conversion program 12.

At first, it is determined whether or not each of the bits 81₁ to 81ₙ₋₁ is "1" (Step S11). The determination is carried out in turn from the high order bit 81ₙ₋₁.

Next, it is determined whether or not each of the bits 81₁ to 81ₙ₋₁ includes the bit of "1" (Step S12).

If any of the bits 81₁ to 81ₙ₋₁ is set "1", j' satisfying the following condition is determined (Step S13). The value j' indicates the position of the most significant bit of the bits for which "1" is set.
Condition: The bits 81_{j'+1} to 81ₙ₋₁ of the bits 81₁ to 81ₙ₋₁ are "0", and the remaining bits 81₁ to 81ⱼ, are "1". However, if all of the bits 81₁ to 81ₙ₋₁ are "1", it is determined to be j'=n-1. The value j' thus determined is any integer between 1 and n-1.

Based on the determined j', the pointer flag 81 is determined to be in the state j (=j'-1). If the pointer flag 81 is determined to be in the state j, the memory region 71ⱼ of the memory regions 71₁ to 71ₙ is selected as the source from which the data is read out. The physical address of the selected memory region 71ⱼ is calculated, and the data of the logical address X is read out from the region indicated by the physical address of the non-volatile memory 4 (Step S13). The process for reading out the data of the logical address X is ended as mentioned above.

On the other hand, at the step S12, if all of the bits 81₁ to 81ₙ₋₁ are "0" and the bit of "0" is not found out, the head memory region 71₁ of the memory regions 71₁ to 71ₙ is selected as the source from which the data is read out. This implies that when the pointer flag 81 is in the state 1, the memory region 71₁ is selected as the source from which the data is read out. The physical address of the selected memory region 71₁ is calculated, and the data of the logical address X is read out from the region indicated by the physical address of the non-volatile memory 4 (Step S14). The process for reading out the data of the logical address X is ended as mentioned above.

As mentioned above, in the semiconductor device in this embodiment, if data is stored in the non-volatile memory 4, a data region 7 is reserved for the data. The reserved data region 7 is comprised of the n memory regions 71₁ to 71ₙ (n is a natural number of 2 or more). If the data is updated and a data after the update is stored in the data region 7, one of the memory regions 71₁ to 71ₙ is circularly selected as the destination to which the data is written. The data is written to the selected memory region.

At this time, the state of the pointer flag 81 is circularly shifted between the first to n-th states, in accordance with the selection of the memory regions 71₁ to 71ₙ. The respective bits 81₁ to 81ₙ₋₁ are rewritten two times during one round of the selection of the memory regions 71₁ to 71ₙ. Thus, if the permissive number of times of rewrite of the non-volatile memory 4 is supposed to be N, the state of the pointer flag 81 can be changed by [n/2]×N times. Here, [x] is the maximum integer that does not exceed x.

As mentioned above, in the semiconductor device in this embodiment, the data stored in the data region 7 can be updated by [n/2]×N times. The permissive number of times of rewrite of the data stored in the data region 7 is greater than the permissive number of times of rewrite which is physically allowed for the non-volatile memory 4.

Moreover, in the semiconductor device in this embodiment, the risk that the data stored in the non-volatile memory 4 is damaged is small, even if the power supply to the respective section of the semiconductor device from the power supply unit 5 is suddenly interrupted during the access to the non-volatile memory 4.

At first, it is supposed that data is written to the data region 7 if the pointer flag 81 is at any state of the states 1 to n-1. Also, it is supposed that the pointer flag 81 is in the state i of the states 1 to n-1. The latest data at this time is stored in the memory region 71ᵢ. If the data to be stored in the data region 7 is updated from that state and written to the data region 7, the data after the update is firstly written to the memory region 71ᵢ₊₁. After that, the bit 81ᵢ of the pointer flag 81 is updated from "0" to "1", and the pointer flag 81 is shifted from the state i to the state i+1.

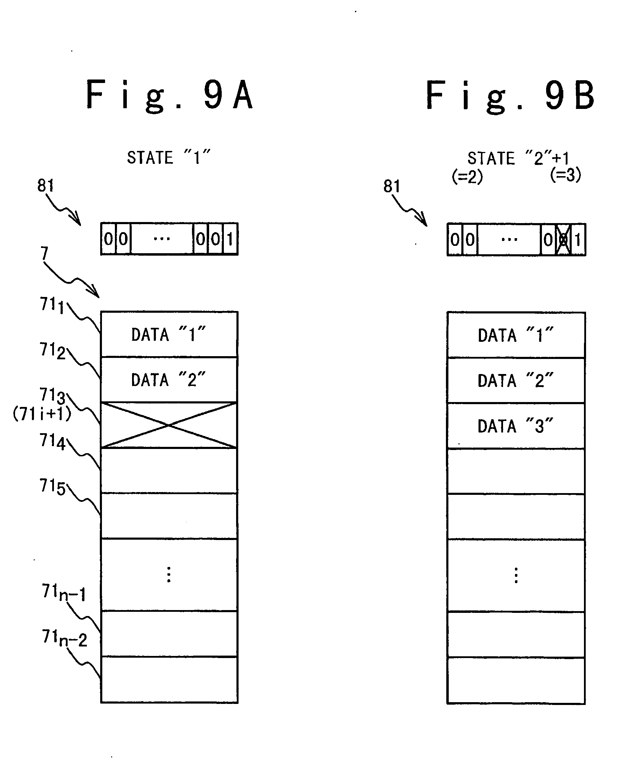

At this time, as shown in Fig. 9A, it is supposed that the data is not normally written to the memory region 71ᵢ₊₁ because of the interruption of the power supply from the power supply unit 5 while the data is written to the memory region 71ᵢ₊₁. Fig. 9A shows the data region 7 and the pointer flag 81 in case of i=2. In this case, the pointer flag 81 is kept at the original state i. Thus, when the data is read out from the data region 7 after that, the data is read out from the memory region 71ᵢ. The latest data normally written is read out.

Moreover, as shown in Fig. 9B, it is supposed that the power supply from the power supply unit 5 is interrupted when the bit 81ᵢ of the pointer flag 81 is updated from "0" to "1". In this case, whether the bit 81ᵢ of the pointer flag 81 is set to "1" or "0" is determined as a probability.

If the bit 81ᵢ of the pointer flag 81 is determined to be "1", this fact implies that the writing process is normally carried out as a result. Thus, there is no problem.

On the other hand, if the bit 81ᵢ of the pointer flag 81 is determined to be "0", this fact implies that the writing process is not normally carried out. However, the pointer flag 81 is kept in the state i. Thus, when the data is read out from the data region 7 after that, the data is read out from the memory region 71₁. Then, the latest data is read out in which the writing process has been normally carried out.

In this way, even if the bit 81ᵢ of the pointer flag 81 is determined to be "1" or "0", it is possible to read out the latest data in which the writing operation has been normally carried out.

Next, it is supposed that data is written to the data region 7 when the pointer flag 81 is in the state n. When the pointer flag 81 is in the state n, the memory region 71₁ is selected as the destination to which the data is written, and the data is written thereto. If the data is not normally written to the memory region 71₁ because of the interruption of the power supply from the power supply unit 5 while the data is written to the memory region 71₁, the pointer flag 81 is kept at the original state n. After that, when the data is read out from the data region 7, the data is read out from the memory region 71ₙ. Thus, even in this case, it is possible to read out the latest data in which the writing operation has been normally carried out.

After the data is written to the memory region 71₁, all of the bits 81₁ to 81ₙ in the pointer flag 81 are cleared to "0". Thus, the pointer flag 81 is shifted from the state n to the state 1. At this time, they are collectively cleared to "0", in accordance with to one command from the CPU 2. Hence, the risk that the content of the pointer flag 81 is damaged is extremely small when they are cleared to "0".

As mentioned above, even if the data is written to the data region 7 when the pointer flag 81 is at any one of the states 1 to n, the risk that the data stored in the non-volatile memory 4 is damaged is small in the semiconductor device in this embodiment.

### (Second Embodiment)

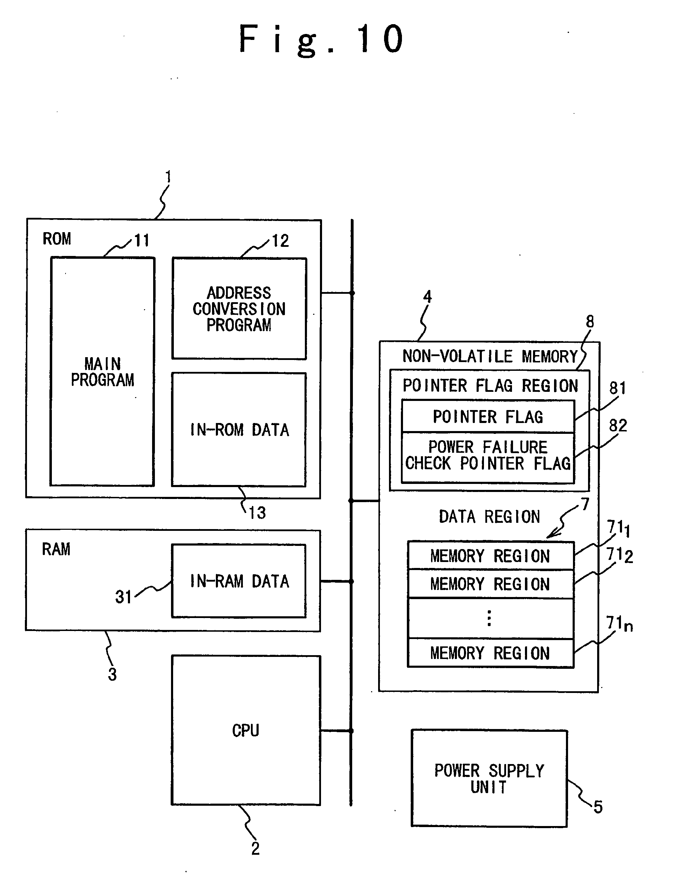

Fig. 10 shows a semiconductor device according to the second embodiment of the present invention. The second embodiment differs from the semiconductor device in the first embodiment in that a power failure check pointer flag 82 is further provided in the pointer flag region 8, in addition to the pointer flag 81. The semiconductor device in the second embodiment uses the power failure check pointer flag 82. Thus, it is possible to detect the interruption of the power supply to the respective sections of the semiconductor device while the data is written to the data region 7.

Moreover, in the semiconductor device in the second embodiment, the contents of the main program 11 and the address conversion program 12 stored in the ROM 2 are modified. This modification corresponds to the fact that the power failure check pointer flag 82 is further installed in the pointer flag region 8.

The configurations of the other portions of the semiconductor device in the second embodiment are the same as those of the semiconductor device in the first embodiment.

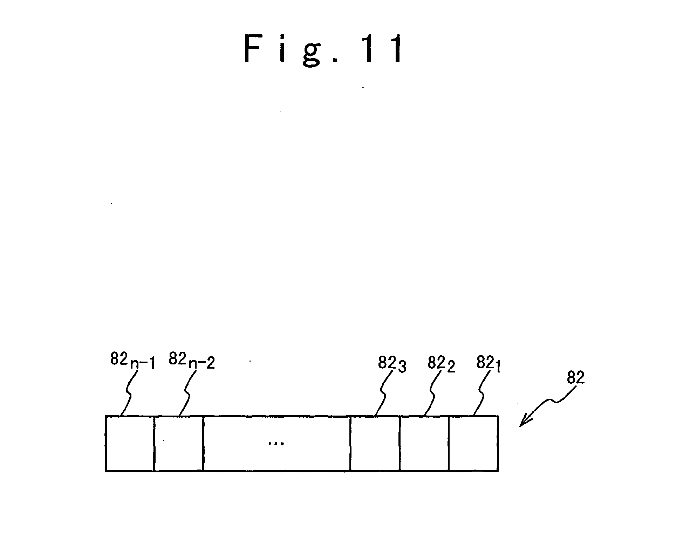

Fig. 11 shows the configuration of the power failure check pointer flag 82. The power failure check pointer flag 82 is provided with (n-1) interruption check bits 82₁ to 82ₙ₋₁. Here, n is the number of the memory regions 71₁ to 71ₙ of the data region 7, as mentioned above. As mentioned above, n is selected such that all of the (n-1) bits 81₁ to 81ₙ₋₁ contained in the pointer flag 81 can be collectively cleared to "0" in accordance with the one command outputted by the CPU 2. Similarly, the (n-1) interruption check bits 82₁ to 82ₙ₋₁ contained in the power failure check pointer flag 82 can be collectively cleared to "0" in accordance with the command outputted by the CPU 2.

The power failure check pointer flag 82 is also at any state of the states 1 to n, similarly to the pointer flag 81. The state 1 is the state in which all of the interruption check bits 82₁ to 82ₙ₋₁ are "0". The state 2 is the state at which the interruption check bit 82₁ is "1" and the remaining interruption check bits 82₂ to 82ₙ₋₁ are "0". Hereafter, similarly, the state k is the state at which the interruption check bits 82₁ to 82ₖ₋₁ are "1" and the remaining interruption check bits 82ₖ to 82ₙ₋₁ are "0". Here, k is an integer between 1 and n. However, in case of k=n, the state n is the state in which all of the interruption check bits 82₁ to 82ₖ₋₁ are "1".

The pointer flag 81 and the power failure check pointer flag 82 are both kept at the same state in the usual condition. However, the interruption of the power supply during the writing process to the data region 7 causes a difference to be induced between the pointer flag 81 and the power failure check pointer flag 82. As described later, this difference enables the interruption of the power supply to be detected.

The operation of the semiconductor device in the second embodiment will be described below.

At first, the operation for writing a data to the data region 7 will be described. In the following description, it is supposed that the data region 7 is assigned to store the data of the logical address X in the memory space. Moreover, data to be firstly stored as the data of the logical address X is supposed to be noted as a data 1.

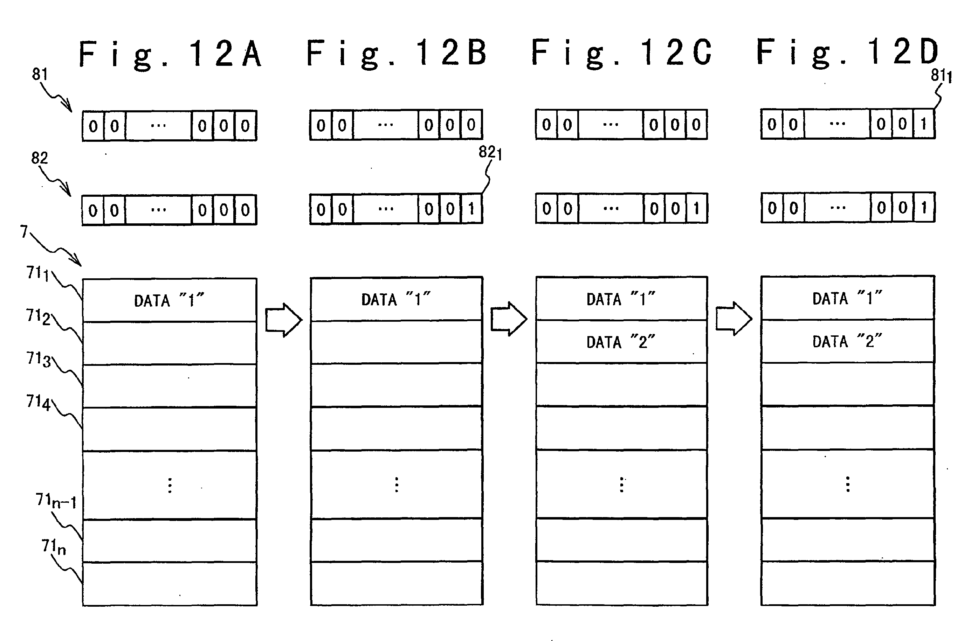

If the data 1 to be firstly stored as the data of the logical address X is written to the data region 7, the following writing process is carried out. At first, the power failure check pointer flag 82 is set in the state 1. That is, all of the interruption check bits 82₁ to 82ₙ₋₁ are set to "0". Next, the data 1 is written to the data region 7. As the data of the logical address X, the data 1 to be firstly written to the data region 7 is written to the memory region 71₁ without any condition. After the data 1 is written to the memory region 71₁, the pointer flag 81 is set in the state 1. That is, all of the bits 81₁ to 81ₙ₋₁ included in the pointer flag 81 are set to "0". Fig. 12A shows the states of the data region 7, the pointer flag 81 and the power failure check pointer flag 82 after the completion of the process for writing the data 1.

After that, if the data of the logical address X is updated, the following updating process is carried out. At first, the address conversion program 12 refers to the pointer flag 81 and the power failure check pointer flag 82, and determines which of the states 1 to n each of the pointer flag 81 and the power failure check pointer flag 82 is set to. The pointer flag 81 and the power failure check pointer flag 82 are usually in the states coincident with each other. If the pointer flag 81 and the power failure check pointer flag 82 are determined to be in the state k (k is an integer between 1 and n), the memory region 71ₖ₊₁ of the memory regions 71₁ to 71ₙ is selected as a destination to which the data after the update is written.

Subsequently, the power failure check pointer flag 82 is shifted from the state k to the state k+1. In detail, the interruption check bit 82ₖ of the power failure check pointer flag 82 is shifted from "0" to "1". However, if the pointer flag 81 and the power failure check pointer flag 82 are in the state n, the power failure check pointer flag 82 is shifted from the state n to the state 1. That is, if the pointer flag 81 and the power failure check pointer flag 82 are in the state n, all of the interruption check bits 82₁ to 82ₙ₋₁ are cleared to "0".

Next, the data after the update of the logical address X is written to the memory region 71ₖ₊₁ of the memory regions 71₁ to 71ₙ. However, if the data of the logical address X is updated when the pointer flag 81 is in the state n, the data to be stored in the data region 7 as the data of the logical address X is written to the memory region 71₁.

After that, the pointer flag 81 is shifted from the state k to the state k+1. In detail, the bit 81ₖ of the pointer flag 81 is shifted from "0" to "1". However, when the pointer flag 81 is in the state n, the pointer flag 81 is shifted from the state n to the state 1. That is, when the pointer flag 81 is in the state n, $81₁ to 81ₙ₋₁ are all cleared to "0".

The process for updating the data of the logical address X is completed as mentioned above.

The above-mentioned processes will be actually described below. As mentioned above, the data 1 to be firstly stored as the data of the logical address X is written to the memory region 71₁ as shown in Fig. 12A. Both of the pointer flag 81 and the power failure check pointer flag 82 are set in the state 1.

If the data of the logical address X is updated from the data 1 to the data 2, the following processes are carried out. At first, the address conversion program 12 refers to the pointer flag 81 and the power failure check pointer flag 82. Both the pointer flag 81 and the power failure check pointer flag 82 are determined to be in the state 1. The memory region 71₂ of the memory regions 71₁ to 71ₙ is selected as the destination to which the data 2 is written. Then, as shown in Fig. 12B, the interruption check bit 82₁ of the power failure check pointer flag 82 is updated from "0" to "1". That is, the power failure check pointer flag 82 is shifted from the state 1 to the state 2. Next, as shown in Fig. 12C, the data 2 is written to the memory region 71₂ selected as the destination to which the data is written. As shown in Fig. 12D, the bit 81₁ in the pointer flag 81 is updated from "0" to "1". That is, the pointer flag 81 is shifted from the state 1 to the state 2. The process for writing the data 2 is ended as mentioned above.

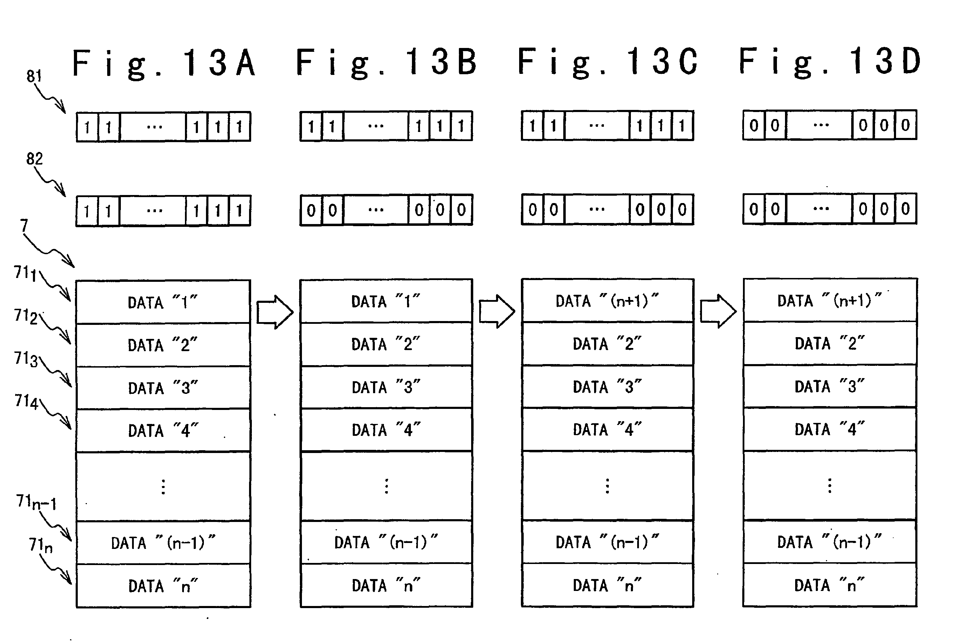

After that, when the data of the logical address X is sequentially updated to the data 3, ..., and the data n, the power failure check pointer flag 82 is sequentially shifted to the state 3, the state 4, ..., and the state n, similarly to the above-mentioned process. The data 3, the data 4, ..., and the data n after the update are written to the memory region 71₄, the memory region 71₅, ..., the memory region 71ₙ. Moreover, the pointer flag 81 is shifted sequentially to the state 3, the state 4, ..., the state n. After the completion of the process for writing the data n, the data n is written to the memory region 71ₙ, as shown in Fig. 13A, and the pointer flag 81 and the power failure check pointer flag 82 are in the state n.

Subsequently, if the data of the logical address X is updated from the data n to the data (n+1), the pointer flag 81 and the power failure check pointer flag 82 are firstly referred. The pointer flag 81 and the power failure check pointer flag 82 are determined to be in the state n. At this time, the memory region 71₁ of the memory regions 71₁ to 71ₙ is selected as the destination to which the data is written. As shown in Fig. 13B, all of the interruption check bits 82₁ to 82ₙ₋₁ of the power failure check pointer flag 82 are cleared to "0", and the power failure check pointer flag 82 is shifted from the state n to the state 1. Next, as shown in Fig. 13C, the data (n+1) is written to the memory region 71₁ selected as the destination to which the data is written. As shown in Fig. 13D, all of the bits 81₁ to 81ₙ₋₁ of the pointer flag 81 are cleared to "0". That is, the pointer flag 81 is shifted from the state n to the state 1. The process for writing the data (n+1) is ended as mentioned above.

The operation for reading out the data from the data region 7 to which the data of the logical address X is written as mentioned above will be described below.

If the data of the logical address X is read out, the address conversion program 12 firstly refers to the pointer flag 81, and determines which of the states 1 to n the pointer flag 81 is set to. At this time, the power failure check pointer flag 82 is not referred. As mentioned above, the power failure check pointer flag 82 is updated before the data is written to the memory regions 71₁ to 71ₙ. There is a case where the power failure check pointer flag 82 does not indicate the memory region of the memory regions 71₁ to 71ₙ in which latest data of the logical address X has been normally written, because the power supply is interrupted from the power supply unit 5 while the data is written to any of the memory regions 71₁ to 71ₙ. Thus, when the data of the logical address X is read out, the power failure check pointer flag 82 is not referred.

If the pointer flag 81 is determined to be in the state j of the states 1 to n (j is an integer between 1 and n), the data stored in the memory region 71j of the memory regions 71₁ to 71ₙ is read out as the data of the logical address X. The process for reading out the data of the logical address X based on the state of the pointer flag 81 is the same as that of the first embodiment. Therefore, the detailed description is not carried out.

The programs for executing the above-mentioned operations are written in the main program 11 and the address conversion program 12 in this embodiment. The CPU 2 executes the above-mentioned operations in accordance with the main program 11 and the address conversion program 12.

In the semiconductor device in the second embodiment, if the data is stored in the non-volatile memory 4, the data region 7 is reserved for the data, similarly to the semiconductor device in the first embodiment. The reserved data region 7 is comprised of the n memory regions 71₁ to 71ₙ (n is a natural number of 2 or more). If the data is updated, one of the memory regions 71₁ to 71ₙ is circularly selected as the destination to which the data is written. The data is written to the selected memory region. Thus, the permissive number of times of rewrite of the data is fictionally greater than the physically permissive number of times of rewrite of the non-volatile memory 4.

Moreover, in the semiconductor device in this embodiment, similarly to the semiconductor device in the first embodiment, the risk that the data stored in the non-volatile memory 4 is damaged is small, even if the power supply to the respective sections of the semiconductor device from the power supply unit 5 is suddenly interrupted during the access to the non-volatile memory 4.

Moreover, in the semiconductor device in this embodiment, it is possible to detect the occurrence of the interruption of the power supply if the power supply from the power supply unit 5 is interrupted during the process for writing the data to the data region 7. If the power supply from the power supply unit 5 is interrupted during the update of the power failure check pointer flag 82, the write of the data to the memory regions 71₁ to 71ₙ and the update of the pointer flag 81, the difference is produced between the state of the pointer flag 81 and the state of the power failure check pointer flag 82. If the power supply from the power supply unit 5 is recovered, the CPU 2 determines whether or not the state of the pointer flag 81 is coincident with the state of the power failure check pointer flag 82, in accordance with the main program 11. Since the state of the pointer flag 81 is not coincident with the state of the power failure check pointer flag 82, the CPU 2 detects the interruption of the power supply from the power supply unit 5 during the process for writing the data to the data region 7. As mentioned above, in the semiconductor device in this embodiment, it is possible to detect the occurrence of the interruption of the power supply.

### (Third Embodiment)

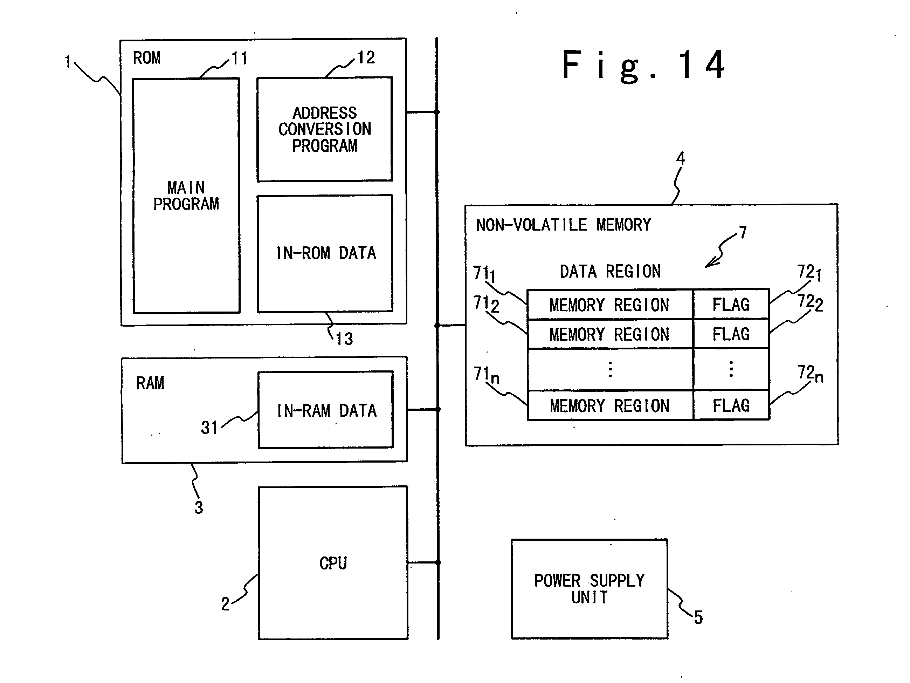

Fig. 14 shows a semiconductor device of the third embodiment according to the present invention. In the semiconductor device of the third embodiment, the pointer flag region 8 is not provided in the non-volatile memory 4. Instead, in the semiconductor device of the third embodiment, flags 72₁ to 72ₙ are added to the memory regions 71₁ to 71ₙ of the data region 7, respectively. Each of the flags 72₁ to 72ₙ stores one-bit data. The data region 7 to which the flags 72₁ to 72ₙ are added is hereafter referred as a data region 7'. Also, the whole of the flags 72₁ to 72ₙ is referred to as a flag set 72.

Moreover, in the semiconductor device of the third embodiment, the contents of the main program 11 and the address conversion program 12 stored in the ROM 2 are modified. This modification corresponds to the fact that the flags 72₁ to 72ₙ are added to the memory regions 71₁ to 71ₙ of the data region 7, respectively.

The flags 72₁ to 72ₙ indicates which of the memory regions 71₁ to 71ₙ of the data region 7' is accessed. Only one of the flags 72₁ to 72ₙ is set to "1", and the other flags are set to "0". The number of the combinations with regard to the values of the flags 72₁ to 72ₙ is n. That is, the number of possible states of the flag set 72 is n.

The correspondence relation between the values kept in the flags 72₁ to 72ₙ and the memory regions to be accessed is as follows. If the flag 72₁ of the flags 72₁ to 72ₙ is "1", the data is read from the memory region 71₁, and the data is written to the memory region 71₂. If the flag 72₂ of the flags 72₁ to 72ₙ is "1", the data is read out from the memory region 71₂, and the data is written to the memory region 71₃. Hereafter, similarly, if the flag 72ₖ of the flags 72₁ to 72ₙ is "1", the data is read out from the memory region 71ₖ, and the data is written to the memory region 71ₖ₊₁. However, if the flag 72ₙ of the flags 72₁ to 72ₙ is "1", the data is written to the memory region 71₁.

The operation of the semiconductor device of the third embodiment will be described below.

At first, the operation for writing data to the data region 7' will be described. In the following description, it is supposed that the data region 7' is assigned to store the data of the logical address X in the memory space. Moreover, it is supposed that the data to be firstly stored as the data of the logical address X' is data 1.

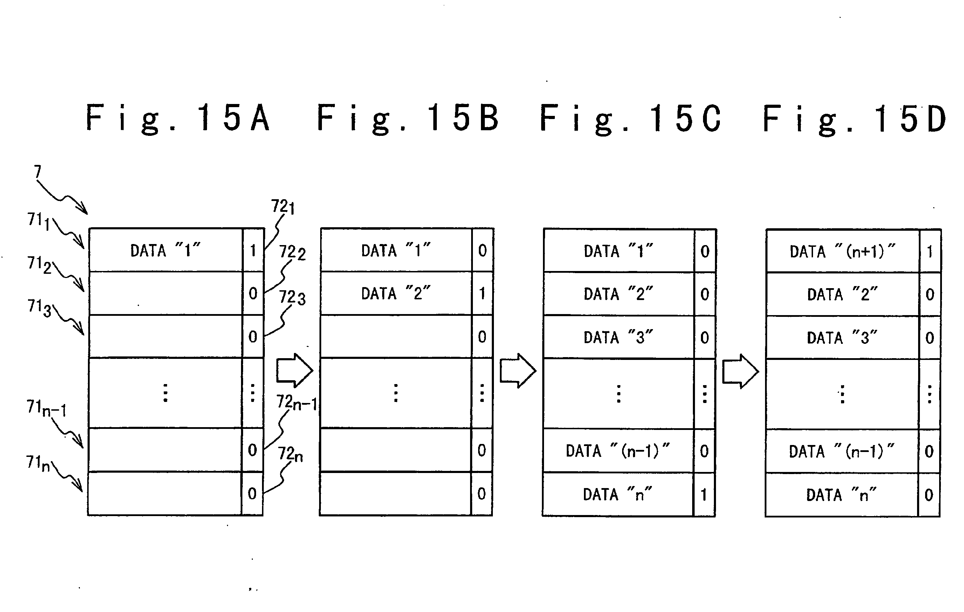

If the data 1 to be firstly stored as the data of the logical address X is written to the data region 7', the following writing process is carried out. At first, the data 1 is written to the memory region 71₁ without any condition. After the data 1 is written to the memory region 71₁, the flag 72₁ is set to the state "1", and the flags 72₂ to 72ₙ are remained set to "0". Fig. 15A shows the state of the data region 7' after the completion of the process for writing the data 1.

After that, when the data of the logical address X is updated, the following updating process is carried out. At first, the address conversion program 12 refers to the flags 72₁ to 72ₙ, and determines which of the flags 72₁ to 72ₙ is "1". If the flag 72ₖ of the flags 72₁ to 72ₙ is determined to be "1" (k is an integer between 1 and n), the memory region 71ₖ₊₁ of the memory regions 71₁ to 71ₙ is selected as a destination to which the data after the update is written. However, if the flag 72ₙ is "1", the memory region 71₁ is selected as the destination to which the data after the update is written.

Next, the data of the logical address X after the update is written to the selected memory region 71ₖ₊₁. However, if the flag 72ₙ is at "1", the data of the logical address X after the update is written to the selected memory region 71₁.

After that, the flag 71ₖ is updated from "1" to "0", and the flag 71ₖ₊₁ is updated from "0" to "1". However, if the flag 72ₙ is "1", the flag 71₁ is updated from "0" to "1".

The process for updating the data of the logical address X is ended as mentioned above.

The above-mentioned processes will be actually described below. As mentioned above, the data 1 to be firstly stored as the data of the logical address X is written to the memory region 71₁ as shown in Fig. 15A. The flag 72₁ is set to "1", and the flags 72₂ to 72ₙ are set to "0".

When the data of the logical address X is updated from the data 1 to the data 2, the following processes are carried out. At first, the flags 72₁ to 72ₙ are referred. If the fact that the flag 72₁ is to "1" and the flags 72₂ to 72ₙ are "0" is detected, the memory region 71₂ of the memory regions 71₁ to 71ₙ is selected as the destination to which the data is written. The data 2 is written to the memory region 71₂ selected as the destination to which the data is written. Next, the flag 72₁ is updated to "0", and the flag 72₂ is updated to "1". The process for updating the data of the logical address X from the data 1 to the data 2 is ended as mentioned above. Fig. 15B shows the states of the data region 7' and the flags 72₁ to 72ₙ when the updating process is ended.

After that, when the data of the logical address X is sequentially updated from the data 2 to the data 3, ..., and the data n, the data 3, the data 4, ..., and the data n after the update are written to the memory region 71₃, the memory region 71₄, ..., the memory region 71ₙ, respectively. Moreover, the flags of "1" of the flags 72₁ to 72ₙ are changed sequentially to the flag 72₃, the flag 72₄, ..., the flag 72ₙ. After the completion of the process for updating the data of the logical address X to the data n, the data n is written to the memory region 71ₙ, as shown in Fig. 15C, and the flag 72ₙ of the flags 72₁ to 72ₙ is set to "1", and the other flags 72₁ to 72ₙ₋₁ are set to "0".

Subsequently, if the data of the logical address X is updated from the data n to the data (n+1), the flags 72₁ to 72ₙ are referred, and the memory region 71₁ of the memory regions 71₁ to 71ₙ is selected as the destination to which the data is written. The data (n+1) is written to the memory region 71₁ selected as the destination to which the data is written. Next, the flag 72₁ is updated to "1", and the flag 72ₙ is updated to "0". The updating process for updating the data of the logical address X from the data n to the data (n+1) is ended as mentioned above. Fig. 15D shows the states of the data region 7' and the flags 72₁ to 72ₙ when the updating process is ended.

The operation for reading out the data from the data region 7' to which the data of the logical address X is written as mentioned above will be described below.

If the data of the logical address X is read out, the address conversion program 12 firstly refers to the flags 72₁ to 72ₙ, and determines which of the flags 72₁ to 72ₙ is "1". At this time, if the flag 72ₖ of the flags 72₁ to 72ₙ is determined to be "1", the data stored in the memory region 71ₖ of the memory regions 71₁ to 71ₙ is read out as the data of the logical address X. The operation for reading out the data from the data region 7' is ended as mentioned above.

The programs for executing the above-mentioned operations is written in the main program 11 and the address conversion program 12 in this embodiment. The CPU 2 executes the above-mentioned operations in accordance with the main program 11 and the address conversion program 12.

In the semiconductor device in the third embodiment, if the data is stored in the non-volatile memory 4, the data region 7 is reserved for the data, similarly to the semiconductor device in the first or second embodiments. The reserved data region 7 is comprised of the n memory regions 71₁ to 71ₙ (n is a natural number of 2 or more). When the data is updated, one of the memory regions 71₁ to 71ₙ is circularly selected as the destination to which the data is written. The data is written to the selected memory region. Thus, the permissive number of times of rewrite of the data is fictionally greater than the physically permissive number of times of rewrite of the non-volatile memory 4.

The present invention provides the technique for fictionally extending the lifetime of the non-volatile memory in which the permissive number of times of rewrite is limited.

Also, the present invention provides the technique for simply determining a memory region to be used for the rewrite and performing the rotation on the memory regions, and thereby fictionally extending the lifetime of the non-volatile memory in which the permissive number of times of rewrite is limited.

Also, the present invention provides the technique for reducing the risk that the data stored in the non-volatile memory is damaged if the power supply to the non-volatile memory is interrupted during the access to the non-volatile memory.

Moreover, the present invention provides the technique for detecting the occurrence of the interruption of the power supply to the non-volatile memory if the power supply to the non-volatile memory is interrupted.

## Claims

1. A semiconductor device comprising:
a non-volatile memory (4); and
a control unit (1, 2, 3) which reserves n memory regions - n is an integer more than 2 - (71₁ to 71ₙ) for n of data as first to n-th memory regions in said non-volatile memory and writes the data in said first memory region, when the data is written in said non-volatile memory, and each time the data is updated, sequentially and circularly writes the updated data as the latest data in said n memory regions;
wherein said control unit reserves a pointer region (81) in said non-volatile memory to indicate an i-th one - i is an integer between 1 and n - of said first to n-th memory regions in which the latest data is written;
wherein said control unit refers to said pointer region to read out the latest data from said i-th memory region;
wherein when the latest data should be further updated, said control unit refers to said pointer region to read out the latest data from said i-th memory region, writes the updated data as the latest data in an (i+1)-th memory region if 1 ≦ i ≦ n-1, and in said first memory region if i = n, and updates said pointer region to indicate said (i+1)-th memory region or said first memory region;
**characterized in that**
said pointer region comprises (n-1) bit regions (81₁ to 81ₙ₋₁) for said n memory regions, and an j-th bit region - j is an integer between 1 and (n-1) of said (n-1) bit regions - indicates said (j+1)-th memory region in which the latest data has been written;
wherein said control unit changes a value of said j-th bit region from a first value to a second value when the latest data is written in said (j+1)-th memory region;
wherein said control unit resets all values of said (n-1) bit regions to the first value when the latest data is written in said first memory region.

2. The semiconductor device according to claim 1, wherein said control unit reserves a power failure check region (82) in said non-volatile memory, and
said power failure check region indicates whether power failure has occurred before the latest data is written in said i-th memory region.

3. The semiconductor device according to claim 2, wherein when the latest data written in said i-th memory region should be further updated, said control unit refers to said pointer region and said power failure check region to determine an (i-1)-th memory region if said power failure check region indicates that the power failure has occurred when the latest data is written in said i-th memory region and said i-th memory region if said power failure check region indicates no power failure when the latest data is written in said i-th memory region, reads out the latest data from said determined memory region, and writes the updated data as the latest data in said memory region next to said determined memory region.

4. The semiconductor device according to any of claims 1 to 3, wherein said control unit determines said n based on information supplied to said control unit.

5. An IC card using the semiconductor device according to any of claims 1 to 4.

6. A method of writing and updating data in a non-volatile memory, comprising the steps of:
(a) reserving n memory regions (n is an integer more than 2) for n of data as first to n-th memory regions in a non-volatile memory when the data is written in said non-volatile memory;
(b) reserving a pointer region in said non-volatile memory, said pointer region indicating that the latest data is written an i-th one (i is an integer between 1 and n) of said first to n-th memory regions;
(c) writing the data in said first memory region as the latest data;
(d) sequentially and circularly writing the latest data in said n memory regions while said i increments by one each time the latest data is updated and the updated data is written as the latest data; and
(e) updating said pointer region to indicate that the latest data has been written in said i-th memory region, when the latest data has been written in said i-th memory region, wherein said (d) sequentially and circularly writing step comprises the step of:
(f) referring to said pointer region to determine said i-th memory region, when said latest data is updated;
(g) reading out the latest data from said i-th memory region; and
(h) writing the updated data as the latest data in an (i+1)-th memory region
**characterized in that** said (h) writing step comprises the steps of:
writing the latest data in said (i+1)-th memory region if 1 ≤ i ≤ n-1; and
writing the latest data in said first memory region if i = n, **in that** said pointer region comprises (n-1) bit regions for said n memory regions,
said (e) updating step comprises the step of: changing a value of said j-th bit region from a first value to a second value when the latest data is written in said (j+1)-th memory region, wherein j is an integer between 1 and (n-1) and
**that** said (e) updating step further comprises the step of:
resetting values of said (n-1) bit regions to the first value when the latest data is written in said first memory region.

7. The method according to claim 6, further comprising the step of:
(i) reserving a power failure check region in said non-volatile memory, and
wherein said (d) sequentially and circularly writing step further comprises the steps of:
when the latest data written in said i-th memory region should be further updated, referring to said pointer region and said power failure check region to determine an (i-1)-th memory region if said power failure check region indicates that the power failure has occurred when the latest data is written in said i-th memory region and said i-th memory region if said power failure check region indicates no power failure when the latest data is written in said i-th memory region;
reading out the latest data from said determined memory region; and
writing the updated data as the latest data in said memory region next to said determined memory region.

8. The method according to any of claims 6 to 7, wherein said (a) reserving step comprises the step of:
determining said n based on given information.

9. A program for executing said method according to any of claims 6 to 8.

## Patentansprüche

1. Halbleitervorrichtung mit:
einem nicht flüchtigen Speicher (4); und
einer Steuereinheit (1, 2, 3), die, wenn die Daten in den nicht flüchtigen Speicher eingeschrieben werden, n Speicherregionen - n ist eine ganze Zahl größer als 2 - (71₁ bis 71ₙ) für n Daten als erste bis n-te Speicherregionen in dem nicht flüchtigen Speicher reserviert und die Daten in die erste Speicherregion schreibt, und die jedes Mal dann, wenn die Daten aktualisiert werden, die aktualisierten Daten als die spätesten Daten in die n Speicherregionen sequenziell und zirkular einschreibt;
wobei die Steuereinheit eine Hinweismarkenregion (81) in den nicht flüchtigen Speicher reserviert, um eine i-te - i ist eine ganze Zahl zwischen 1 und n - der ersten bis n-ten Speicherregionen, in welcher die spätesten Daten eingeschrieben sind, anzuzeigen;
wobei die Steuereinheit auf diese Hinweismarkenregion Bezug nimmt, um die spätesten Daten aus der i-ten Speicherregion auszulesen;
wobei, wenn die spätesten Daten weiter aktualisiert werden sollten, die Steuereinheit auf die Hinweismarkenregion Bezug nimmt, um die spätesten Daten aus der i-ten Speicherregion auszulesen, die aktualisierten Daten als die spätesten Daten in eine (i + 1)-te Speicherregion einschreibt, wenn 1 ≤ i ≤ n - 1 ist, und in die erste Speicherregion einschreibt, wenn i = n gilt, und die Hinweismarkenregion aktualisiert, um die (i + 1)-te Speicherregion oder die erste Speicherregion anzuzeigen;
**dadurch gekennzeichnet, dass**
die Hinweismarkenregion (n- 1) Bitregionen (81₁ bis 81ₙ₋₁) für die n Speicherregionen aufweist, und dass eine j-te Bitregion - j ist eine ganze Zahl zwischen 1 und (n - 1) - die (j + 1)-te Speicherregion anzeigt, in welche die spätesten Daten eingeschrieben sind;
wobei die Steuereinheit einen Wert der j-ten Bitregion von einem ersten Wert auf einen zweiten Wert ändert, wenn die spätesten Daten in die (j + 1)-te Speicherregion eingeschrieben sind;
wobei die Steuereinheit alle Werte der (n - 1) Bitregionen auf den ersten Wert rücksetzt, wenn die spätesten Daten in die erste Speicherregion eingeschrieben sind.

2. Halbleitervorrichtung nach Anspruch 1, wobei die Steuereinheit eine Energieausfallüberprüfungsregion (82) in dem nicht flüchtigen Speicher reserviert, und
die Energieausfallüberprüfungsregion anzeigt, ob ein Energieausfall aufgetreten ist, bevor die spätesten Daten in die i-te Speicherregion eingeschrieben worden sind.

3. Halbleitervorrichtung nach Anspruch 2, wobei, wenn die spätesten Daten die in die i-te Speicherregion eingeschrieben sind, weiter aktualisiert werden sollten, die Steuereinheit auf die Hinweismarkenregion und die Energieausfallüberprüfungsregion Bezug nimmt, um eine (i - 1)-te Speicherregion zu bestimmen, wenn die Energieausfallüberprüfungsregion anzeigt, dass der Energieausfall aufgetreten ist, wenn die spätesten Daten in die i-te Speicherregion eingeschrieben sind, und die i-te Speicherregion zu bestimmen, wenn die Energieausfallüberprüfungsregion keinen Energieausfall anzeigt, wenn die spätesten Daten in die i-te Speicherregion eingeschrieben sind, die spätesten Daten aus der bestimmten Speicherregion ausliest und die aktualisierten Daten als die spätesten Daten in die zu der bestimmten Speicherregion nächste Speicherregion einschreibt.

4. Halbleitervorrichtung nach einem der Ansprüche 1 bis 3, wobei die Steuereinheit n basierend auf der Steuereinheit zugeführter Information bestimmt.

5. IC-Karte, die die Halbleitervorrichtung gemäß einem der Ansprüche 1 bis 4 verwendet.

6. Verfahren zum Einschreiben und Aktualisieren von Daten in einem nicht flüchtigen Speicher, mit den Schritten:
(a) Reservieren von n Speicherregionen (n ist eine ganze Zahl größer als 2) für n Daten als erste bis n-te Speicherregionen in einem nicht flüchtigen Speicher, wenn die Daten in den nicht flüchtigen Speicher eingeschrieben sind;
(b) Reservieren einer Hinweismarkenregion in dem nicht flüchtigen Speicher, wobei die Hinweismarkenregion anzeigt, dass die spätesten Daten in eine i-te (i ist eine ganze Zahl zwischen 1 und n) der ersten bis n-ten Speicherregionen eingeschrieben sind;
(c) Einschreiben der Daten in die erste Speicherregion als die spätesten Daten;
(d) sequenzielles und zirkulares Einschreiben der spätesten Daten in die n Speicherregionen, während i jedes Mal um eins erhöht wird, wenn die spätesten Daten aktualisiert werden und die aktualisierten Daten als späteste Daten eingeschrieben sind; und
(e) Aktualisieren der Hinweismarkenregion, um anzuzeigen, dass die spätesten Daten in die i-te Speicherregion eingeschrieben sind, wenn die spätesten Daten in die i-te Speicherregion eingeschrieben sind, wobei der Schritt (d) sequenzielles und zirkulares Einschreiben den Schritt aufweist:
(f) Bezug nehmen auf die Hinweismarkenregion, um die i-te Speicherregion zu bestimmen, wenn die spätesten Daten aktualisiert sind;
(g) Auslesen der spätesten Daten aus der i-ten Speicherregion; und
(h) Einschreiben der aktualisierten Daten als die spätesten Daten in eine (i + 1)-te Speicherregion,
**dadurch gekennzeichnet, dass** der Schritt (h) Einschreiben die Schritte aufweist:
Einschreiben der spätesten Daten in die (i + 1)-te Speicherregion, wenn 1 ≤ i ≤ n - 1 gilt; und
Einschreiben der spätesten Daten in die erste Speicherregion, wenn i = n gilt;
**dass** die Hinweismarkenregion (n - 1) Bitregionen für die n Speicherregionen aufweist,
der Schritt (e) Aktualisieren den Schritt aufweist:
Ändern eines Wertes der j-ten Bitregion von einem ersten Wert auf einen zweiten Wert, wenn die spätesten Daten in die (j + 1)-te Speicherregion eingeschrieben sind, wobei j eine ganze Zahl zwischen 1 und (n - 1) ist, und
**dass** der Schritt (e) Aktualisieren fernerhin den Schritt aufweist;
Rücksetzen der Werte der (n - 1) Bitregionen auf den ersten Wert, wenn die spätesten Daten in die erste Speicherregion eingeschrieben sind.

7. Verfahren nach Anspruch 6, weiterhin mit dem Schritt:
(i) Reservieren einer Energieausfallüberprüfungsregion in dem nicht flüchtigen Speicher und
wobei der Schritt (d) sequenzielles und zirkulares Einschreiben fernerhin die Schritte aufweist:
wenn die spätesten Daten, die in i-te Speicherregion eingeschrieben sind, weiter aktualisiert werden sollten, Bezug nehmen auf die Hinweismarkenregion und die Energieausfallüberprüfungsregion, um eine (i - 1)-te Speicherregion zu bestimmen, wenn die Energieausfallüberprüfungsregion anzeigt, dass der Energieausfall aufgetreten ist, wenn die spätesten Daten in die i-te Speicherregion eingeschrieben sind, und die i-te Speicherregion zu bestimmen, wenn die Energieausfallüberprüfungsregion keinen Energieausfall beim Einschreiben der spätesten Daten in die i-te Speicherregion anzeigt;
Auslesen der spätesten Daten aus der bestimmten Speicherregion; und
Schreiben der aktualisierten Daten als die spätesten Daten in die zur bestimmten Speicherregion nächste Region.

8. Verfahren nach einem der Ansprüche 6 bis 7, wobei der Schritt (a)
Reservieren den Schritt aufweist:
Bestimmen von n basierend auf gegebener Information.

9. Programm zur Durchführung des Verfahrens nach einem der Ansprüche 6 bis 8.

## Revendications

1. Dispositif à semiconducteur comprenant :
une mémoire non volatile (4) ; et
une unité de commande (1, 2, 3) réservant n régions de mémoire (n étant un nombre entier supérieur à 2) (71₁ à 71ₙ) pour n des données comme première à n^{ième} régions de mémoire dans ladite mémoire non volatile et écrivant les données dans ladite première région de mémoire, lorsque les données sont écrites dans ladite mémoire non volatile et à chaque fois que les données sont mises à jour, écrivant de manière séquentielle et circulaire les données mises à jour comme les données les plus récentes dans lesdites n régions de mémoire ;
dans lequel ladite unité de commande réserve une région de pointeur (81) dans ladite mémoire non volatile pour indiquer une i^{ième} région (i étant un nombre entier compris entre 1 et n) desdites première à n^{ième} régions de mémoire dans laquelle les données les plus récentes sont écrites ;
dans lequel ladite unité de commande se réfère à ladite région de pointeur pour lire les données les plus récentes dans ladite i^{ième} région de mémoire ;
dans lequel lorsque les données les plus récentes doivent encore être mises à jour, ladite unité de commande se réfère à ladite région de pointeur pour lire les données les plus récentes dans ladite i^{ième} région de mémoire, écrit les données mises à jour comme les données les plus récentes dans une (i + 1)^{ième} région de mémoire si 1 ≤ i ≤ n - 1 et dans ladite première région de mémoire si i = n et met à jour ladite région de pointeur pour indiquer ladite (i + 1)^{ième} région de mémoire ou ladite première région de mémoire ;
**caractérisé en ce que** :
ladite région de pointeur comprend (n-1) régions de bit (81₁ à 81ₙ₋₁) pour lesdites n régions de mémoire et une j^{ième} région de bit (j étant un nombre entier compris entre 1 et (n - 1) desdites (n - 1) régions de bit) indique ladite (j + 1)^{ième} région de mémoire dans laquelle les données les plus récentes ont été écrites ;
dans lequel ladite unité de commande modifie une valeur de ladite j^{ième} région de bit d'une première valeur à une seconde valeur lorsque les données les plus récentes sont écrites dans ladite (j + 1)^{ième} région de mémoire ;
dans lequel ladite unité de commande réinitialise toutes les valeurs desdites (n - 1) régions de bit à la première valeur lorsque les données les plus récentes sont écrites dans ladite première région de mémoire.

2. Dispositif à semiconducteur selon la revendication 1, dans lequel ladite unité de commande réserve une région de vérification de panne de courant (82) dans ladite mémoire non volatile, et
ladite région de vérification de panne de courant indique si la panne de courant s'est produite avant que les données les plus récentes ne soient écrites dans ladite i^{ième} région de mémoire.

3. Dispositif à semiconducteur selon la revendication 2, dans lequel lorsque les données les plus récentes écrites dans ladite i^{ième} région de mémoire doivent encore être mises à jour, ladite unité de commande se réfère à ladite région de pointeur et à ladite région de vérification de panne de courant pour déterminer une (i - 1)^{ième} région de mémoire si ladite région de vérification de panne de courant indique que la panne de courant s'est produite lors de l'écriture des données les plus récentes dans ladite i^{ième} région de mémoire et ladite i^{iéme} région de mémoire si ladite région de vérification de panne de courant n'indique pas de panne de courant lors de l'écriture des données les plus récentes dans ladite i^{ième} région de mémoire, lit les données les plus récentes dans ladite région de mémoire déterminée et écrit les données mises à jour comme les données les plus récentes dans ladite région de mémoire à côté de ladite région de mémoire déterminée.

4. Dispositif à semiconducteur selon l'une quelconque des revendications 1 à 3, dans lequel ladite unité de commande détermine ledit n sur la base des informations fournies à ladite unité de commande.

5. Carte à circuit intégré utilisant le dispositif à semiconducteur selon l'une quelconque des revendications 1 à 4.

6. Procédé d'écriture et de mise à jour de données dans une mémoire non volatile, comprenant les étapes consistant à :
(a) réserver n régions de mémoire (n étant un nombre entier supérieur à 2) pour n des données comme première à n^{ième} régions de mémoire dans une mémoire non volatile lorsque les données sont écrites dans ladite mémoire non volatile ;
(b) réserver une région de pointeur dans ladite mémoire non volatile, ladite région de pointeur indiquant que les données les plus récentes sont écrites dans une i^{ième} région (i étant un nombre entier compris entre 1 et n) desdites première à n^{ième} régions de mémoire ;
(c) écrire les données dans ladite première région de mémoire comme les données les plus récentes ;
(d) écrire de manière séquentielle et circulaire les données les plus récentes dans lesdites n régions de mémoire tandis que ledit i est incrémenté de 1 à chaque fois que les données les plus récentes sont mises à jour et que les données mises à jour sont écrites comme les données les plus récentes ; et
(e) mettre à jour ladite région de pointeur pour indiquer que les données les plus récentes ont été écrites dans ladite i^{ième} région de mémoire, lorsque les données les plus récentes ont été écrites dans ladite i^{ième} région de mémoire, dans lequel ladite étape d'écriture séquentielle et circulaire (d) comprend l'étape consistant à :
(f) se référer à ladite région de pointeur pour déterminer ladite i^{ième} région de mémoire, lorsque lesdites données les plus récentes sont mises à jour ;
(g) lire les données les plus récentes dans ladite i^{ième} région de mémoire ; et
(h) écrire les données mises à jour comme les données les plus récentes dans une (i + 1)^{ième} région de mémoire
**caractérisé en ce que** ladite étape d'écriture (h) comprend les étapes consistant à :
écrire les données les plus récentes dans ladite (i + 1)^{ième} région de mémoire si 1≤ i ≤ n - 1 ; et
écrire les données les plus récentes dans ladite première région de mémoire si i = n,
**en ce que** ladite région de pointeur comprend (n - 1) régions de bit pour lesdites n régions de mémoire,
ladite étape de mise à jour (e) comprend l'étape consistant à : modifier une valeur de ladite j^{ième} région de bit d' une première valeur à une seconde valeur lorsque les données les plus récentes sont écrites dans ladite (j + 1)^{ième} région de mémoire, dans lequel j est un nombre entier compris entre 1 et (n - 1) et
**en ce que** ladite étape de mise à jour (e) comprend en outre l'étape consistant à :
réinitialiser les valeurs desdites (n - 1) régions de bit à la première valeur lorsque les données les plus récentes sont écrites dans ladite première région de mémoire.

7. Procédé selon la revendication 6, comprenant en outre l'étape consistant à :
(i) réserver une région de vérification de panne de courant dans ladite mémoire non volatile, et
dans lequel ladite étape d'écriture séquentielle et circulaire (d) comprend en outre les étapes consistant à :
lorsque les données les plus récentes écrites dans ladite i^{ième} région de mémoire doivent encore être mises à jour, se référer à ladite région de pointeur et à ladite région de vérification de panne de courant pour déterminer une (i - 1) ^{ième} région de mémoire si ladite région de vérification de panne de courant indique que la panne de courant s'est produite lors de l'écriture des données les plus récentes dans ladite i^{ième} région de mémoire et ladite i^{ième} région de mémoire si ladite région de vérification de panne de courant n'indique pas de panne de courant lors de l'écriture des données les plus récentes dans ladite i^{ième} région de mémoire ;
lire les données les plus récentes dans ladite région de mémoire déterminée ; et
écrire les données mises à jour comme les données les plus récentes dans ladite région de mémoire à côté de ladite région de mémoire déterminée.

8. Procédé selon l'une quelconque des revendications 6 à 7, dans lequel ladite étape de réservation (a) comprend l'étape consistant à :
déterminer ledit n sur la base des informations données.

9. Programme d'exécution dudit procédé selon l'une quelconque des revendications 6 à 8.
